# EUROPEAN PATENT APPLICATION

(11) **EP 4 412 421 A1**
(43) Date of publication of application: **07.08.2024**
(21) Application number: 22875496.6
(22) Date of filing: 21.06.2022
(51) Int. Cl.: H05K 13/04, H05K 13/08

(54) **MOUNTING MACHINE**

(30) Priority: 30.09.2021 JP 2021161403
(71) Applicant: Panasonic Intellectual Property Management Co., Ltd., Kadoma-shi, Osaka 571-0057 (JP)
(72) Inventor: SHIBATA, Satoru, Kadoma-shi, Osaka 571-0057 (JP); KITADA, Takashi, Kadoma-shi, Osaka 571-0057 (JP)
(74) Representative: Eisenführ Speiser
(86) International application number: PCT/JP2022/024724
(87) International publication number: WO 2023/053617

(57) **Abstract**

A mounting machine includes a rotary head that includes a plurality of suction nozzles disposed circumferentially, the rotary head being configured to suck a component at a distal end portion of a suction nozzle among the plurality of suction nozzles to mount the component on a board, a sensor that includes a light source and a light receiver, the light source being configured to emit a light ray to the distal end portion of the suction nozzle, the light receiver being configured to receive the light ray emitted from the light source, and the sensor being configured to output light intensity of the light ray received by the light receiver, and a controller that determines, based on the light intensity of the light ray output from the sensor, whether or not the suction nozzle is sucking the component when the rotary head rotates the plurality of suction nozzles in a circumferential direction and the suction nozzle passes through the light ray. The rotary head rotates the plurality of suction nozzles in the circumferential direction when the rotary head is present between the light source and the light receiver and the light ray does not coincide with a rotation center of the rotary head in bottom view.

## Description

### TECHNICAL FIELD

The present disclosure relates to a mounting machine.

### BACKGROUND ART

PTL 1 discloses a component mounting device in which a rotary head equipped with a plurality of suction nozzles is intermittently rotated to sequentially move the suction nozzles from a component suction position to a component mounting position, the suction nozzle that holds an electronic component at a component supply position to move the electronic component to the component mounting position is lowered, the held electronic component is mounted on a circuit board of which a mounting position is moved immediately below the component mounting position, and the holding of the electronic component by the suction nozzle is released to raise the suction nozzle. The component mounting device determines whether or not a holding state and/or a mounting state of the component by the suction nozzle is favorable based on a lapse of time at the time of lowering and/or raising the suction nozzle until the suction nozzle or the component passes through a predetermined height position from the start of lowering of the suction nozzle from the component mounting position.

### Citation List

### Patent Literature

PTL 1: Unexamined Japanese Patent Publication No. 2002-208800

### SUMMARY OF THE INVENTION

The present disclosure has been made in view of the above-described conventional circumstances, and an object of the present disclosure is to provide a mounting machine that more accurately detects a component sucked by each of a plurality of suction nozzles provided in a head of a rotary type.

A mounting machine according to the present disclosure includes a rotary head that includes a plurality of suction nozzles disposed circumferentially, the rotary head being configured to suck a component at a distal end portion of a suction nozzle among the plurality of suction nozzles to mount the component on a board, a sensor that includes a light source and a light receiver, the light source being configured to emit a light ray to the distal end portion of the suction nozzle, the light receiver being configured to receive the light ray emitted from the light source, and the sensor being configured to output light intensity of the light ray received by the light receiver, and a controller that determines, based on the light intensity of the light ray output from the sensor, whether or not the suction nozzle is sucking the component when the rotary head rotates the plurality of suction nozzles in a circumferential direction and the suction nozzle passes through the light ray. The rotary head rotates the plurality of suction nozzles in the circumferential direction when the rotary head is present between the light source and the light receiver and the light ray does not coincide with a rotation center of the rotary head in bottom view.

In addition, a mounting machine according to the present disclosure includes a rotary head that includes a plurality of suction nozzles disposed circumferentially, the rotary head being configured to suck a component at a distal end portion of a suction nozzle among the plurality of suction nozzles to mount the component on a board, a sensor that includes a transmissive illumination and an image sensor, the transmissive illumination being configured to emit a light ray to the distal end portion of the suction nozzle, the image sensor being configured to receive the light ray emitted from the transmissive illumination, and the sensor being configured to generate a captured image on which the suction nozzle when the rotary head rotates the plurality of suction nozzles in a circumferential direction and the suction nozzle passes through the light ray is captured based on the light ray received by the image sensor, and a controller that acquires a shadow of the suction nozzle captured on the captured image output from the sensor, and determines whether or not the suction nozzle is sucking the component based on the shadow. The rotary head rotates the plurality of suction nozzles in the circumferential direction when the rotary head is present between the transmissive illumination and the image sensor and the light ray does not coincide with a rotation center of the rotary head in bottom view.

According to the present disclosure, it is possible to more accurately detect the component sucked by each of the plurality of suction nozzles provided in the head of the rotary type.

### BRIEF DESCRIPTION OF THE DRAWINGS

Fig. 1 is a block diagram illustrating an internal configuration example of a mounting machine according to a first exemplary embodiment.
Fig. 2 is a diagram for describing a partial configuration example of the mounting machine according to the first exemplary embodiment.
Fig. 3 is an enlarged view of main parts of the mounting machine.
Fig. 4 is a diagram for describing component detection by a measurement system.
Fig. 5 is a diagram for describing a positional relationship between a light ray and each of a plurality of suction nozzles.
Fig. 6 is a diagram for describing the positional relationship between the light ray and each of the plurality of suction nozzles.
Fig. 7 is a diagram for describing an example of a correspondence relationship between positions of the suction nozzle and a component and an IV converted value.
Fig. 8 is a diagram for describing a detection determination processing example of the component according to a first exemplary embodiment.
Fig. 9 is a block diagram illustrating an internal configuration example of a mounting machine according to a modification of the first exemplary embodiment.
Fig. 10 is a diagram for describing a detection determination processing example of a component according to the modification of the first exemplary embodiment.
Fig. 11 is a block diagram illustrating an internal configuration example of a mounting machine according to a second exemplary embodiment.
Fig. 12 is a diagram for describing a detection determination processing example of a component according to the second exemplary embodiment.

### DESCRIPTION OF EMBODIMENT

### (Background to the present disclosure)

In the related art, there is a mounting machine that detects an electronic component (hereinafter, referred to as a "component") sucked to a distal end portion of a suction nozzle by using an optical sensor and determines whether or not a suction state of the component is favorable. The component mounting device (hereinafter, referred to as a "mounting machine") of PTL 1 includes the rotary head disposed on the circuit board (hereinafter, referred to as a "board"), and the optical sensor disposed to correspond to the suction nozzle for mounting the component on the board among the plurality of suction nozzles included in the rotary head and the component mounting position. The mounting machine detects the suction nozzle that is raised and lowered at the position corresponding to the component mounting position at the predetermined height, and determines whether or not the component is normally sucked based on a lapse of time at the time of lowering and/or raising the suction nozzle.

However, in the component mounting method described above, since the XY table is positioned to correspond to the component mounting position, there is a possibility that the component mounted on the board is displaced by the positioning operation of the board by the XY table. In addition, in the component mounting method, in a case where the component suction position and the component mounting position are sufficiently separated from each other and the component is conveyed from the component suction position to the component mounting position, since the rotary head cannot be rotated to sequentially move each suction nozzle from the component supply position to the component mounting position, there is a possibility that the component mounting efficiency decreases.

In addition, as another method for determining whether or not the suction state of the component is favorable by using the optical sensor, there is a method for determining whether or not the component is sucked to each suction nozzle by providing the light source of the optical sensor at the rotation center of each of the plurality of suction nozzles disposed circumferentially and receiving the light ray emitted from the light source by the light receiver disposed radially outside the suction nozzle. However, in such a case, since the optical sensor is provided on the rotation shaft of the rotor and rotates with the rotation of each of the plurality of suction nozzles in the circumferential direction, it may not determine whether or not the component is sucked to each suction nozzle.

Hereinafter, exemplary embodiments specifically disclosing a configuration and an action of a mounting machine according to the present disclosure will be described in detail with reference to the drawings as appropriate. It is noted that a more detailed description than need may be omitted. For example, a detailed description of a well-known matter and a repeated description of substantially an identical configuration may be omitted. This is to avoid the unnecessary redundancy in the following description and to make the descriptions easier to understand for those skilled in the art. Note that, the accompanying drawings and the following description are provided for those skilled in the art to fully understand the present disclosure, and are not intended to limit the subject matter described in the scope of claims.

In addition, hereinafter, in each drawing, an X-direction and a Y-direction are directions orthogonal to each other in a horizontal plane. A Z-direction is a height direction (up-down direction) orthogonal to the X-direction and the Y-direction.

### (First exemplary embodiment)

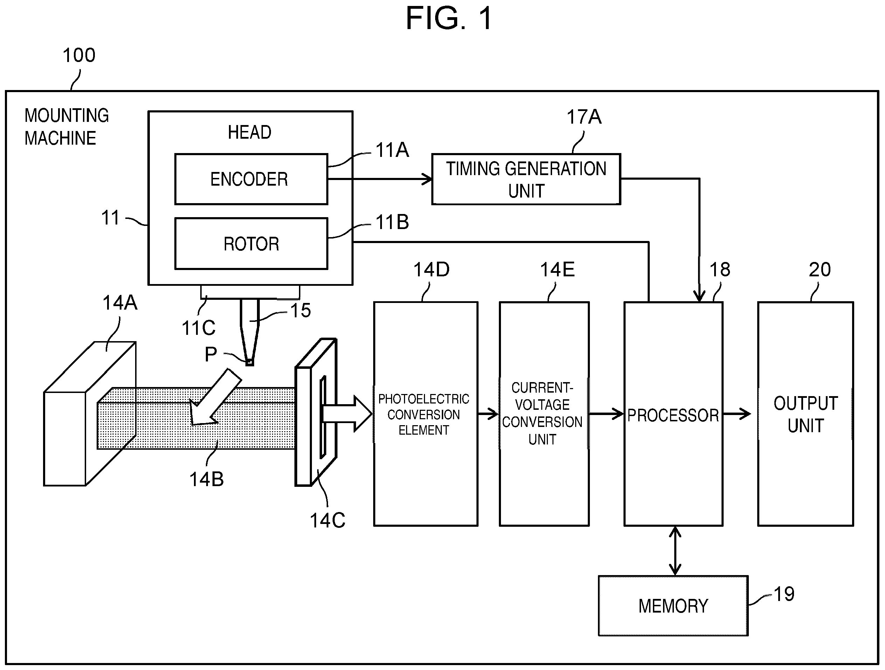

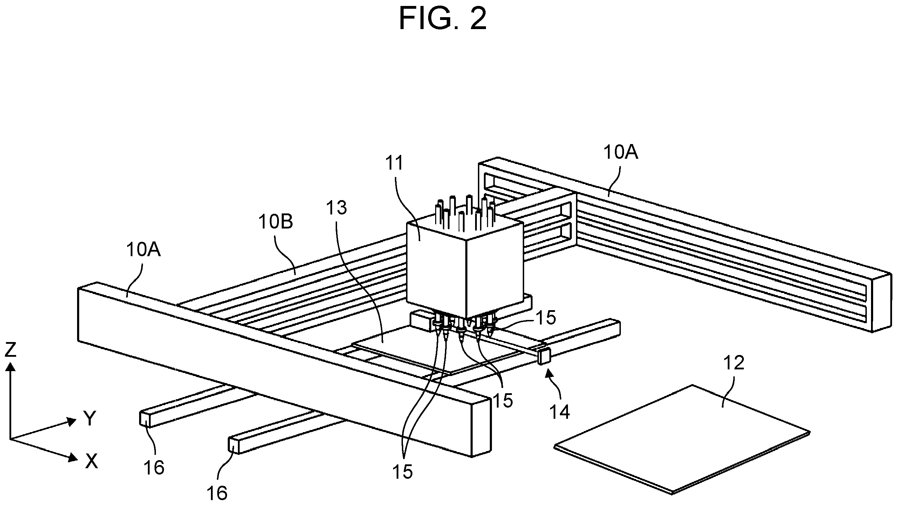

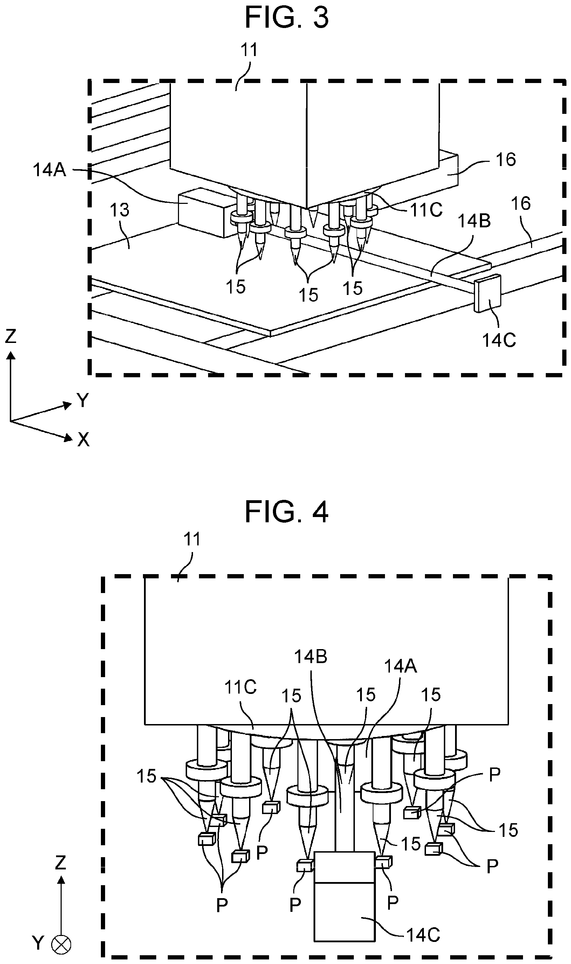

First, an internal configuration of mounting machine 100 according to a first exemplary embodiment will be described with reference to Figs. 1 to 3. Fig. 1 is a diagram for describing an internal configuration example of mounting machine 100 according to the first exemplary embodiment. Fig. 2 is a diagram for describing a partial configuration example of mounting machine 100 according to the first exemplary embodiment. Fig. 3 is an enlarged view of main parts of mounting machine 100.

Note that, in Fig. 1, only one suction nozzle 15 is illustrated, and other suction nozzles are not illustrated. In addition, in Fig. 1, X-axis rails 10A, Y-axis rail 10B, component supply unit 12, board 13, and board rails 16 are not illustrated.

Mounting machine 100 according to the first exemplary embodiment drives the pair of board rails 16 to load board 13. Mounting machine 100 drives head 11 including one or more suction nozzles 15 to cause each of suction nozzles 15 to suck component P (see Fig. 3) supplied by component supply unit 12. After component P is sucked by suction nozzle 15, mounting machine 100 moves head 11 onto board 13 to convey component P onto board 13, and then mounts component P at each component mounting position on board 13. Mounting machine 100 mounts (attaches) all the components P to be mounted on board 13 to produce a mounting board, and then drives each of the pair of board rails 16 to unload the produced mounting board.

Mounting machine 100 includes head 11, component supply unit 12, measurement system 14, one or more suction nozzles 15, a pair of board rails 16, timing generation unit 17A, processor 18, memory 19, and output unit 20.

The pair of X-axis rails 10A is combined with Y-axis rail 10B, and supports Y-axis rail 10B to be movable in the X-direction and a -X-direction. Y-axis rail 10B is combined with head 11, and supports head 11 to be movable in the Y-direction and a -Y-direction. The pair of X-axis rails 10A and Y-axis rail 10B constitute a moving mechanism that moves head 11.

Head 11 as an example of a rotary head is formed integrally with measurement system 14, and is driven (moved) in each of the X-axis direction, the Y-axis direction, and the Z-axis direction under the control of the moving mechanism. Head 11 is combined with Y-axis rail 10B, and conveys component P between component supply unit 12 and a predetermined component mounting position on board 13.

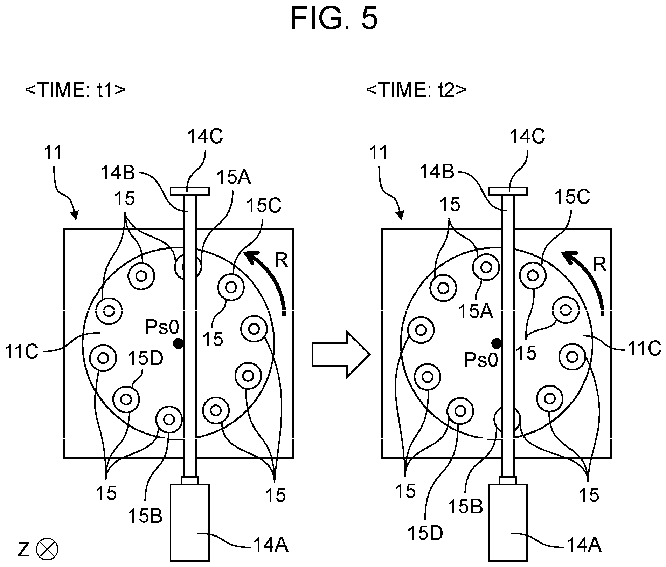

Head 11 is a so-called rotary head, and includes encoder 11A, rotor 11B, rotary table 11C, and a plurality of suction nozzles 15. Rotary table 11C includes the plurality of suction nozzles 15 disposed concentrically. Rotor 11B rotates rotary table 11C in predetermined rotation direction R (see Fig. 5), and thus, each of the plurality of suction nozzles 15 mounted on rotary table 11C is rotated in predetermined rotation direction R. Encoder 11A detects a rotation angle of rotor 11B by a sensor (not illustrated), and outputs the detected rotation angle to timing generation unit 17A.

Head 11 causes processor 18 to execute suction and suction release of component P by each of suction nozzles 15. Head 11 mounts component P on board 13 by sucking component P supplied by component supply unit 12 at a distal end portion of suction nozzle 15, conveys component P to a predetermined component mounting position on board 13, and then releases the suction of the component.

Note that, head 11 may not be formed integrally with measurement system 14. In such a case, after component P is sucked by the moving mechanism, head 11 moves rotary table 11C to a position where the rotary table is positioned on light source 14A, and then rotates rotary table 11C by rotor 11B on light source 14A. Head 11 rotates rotary table 11C such that components P sucked by all suction nozzles 15 can be detected by measurement system 14.

Component supply unit 12 is controlled by processor 18 to supply component P mounted on board 13. Note that, component supply unit 12 may be able to simultaneously supply a plurality of different types of components P. In addition, the disposition of component supply unit 12 illustrated in Fig. 2 is an example and is not limited thereto.

Measurement system 14 as an example of a sensor includes light source 14A, slit 14C, photoelectric conversion element 14D, and current-voltage conversion unit 14E, and is formed integrally with head 11. Slit 14C is disposed on a surface facing light source 14A. Light source 14A and slit 14C are disposed to be separated by a distance (specifically, a diameter of rotary table 11C) at which head 11 including the plurality of suction nozzles 15 can pass or more. Note that, a disposition position of measurement system 14 illustrated in each of Figs. 1 to 3 is an example and is not limited thereto.

For example, photoelectric conversion element 14D as an example of a light receiver converts light (light ray 14B) emitted from light source 14A such as a light emitting diode (LED), a laser diode (LD), or a laser and passing through slit 14C into an electric signal, and outputs the electric signal to current-voltage conversion unit 14E. Current-voltage conversion unit 14E converts an electric signal (current) output from photoelectric conversion element 14D into a voltage, and outputs a converted output value (hereinafter, referred to as a "IV converted value") to processor 18.

Timing generation unit 17A as an example of a determination unit generates an electric signal for causing processor 18 to execute detection determination of component P based on the rotation angle of rotor 11B output from encoder 11A of head 11. Timing generation unit 17A outputs the generated electric signal to processor 18. Note that, here, timing generation unit 17A may specify one suction nozzle 15 that is a detection determination target of component P based on the rotation angle of rotor 11B, and may output identification information capable of identifying specified suction nozzle 15 and the generated electric signal to processor 18 in association with each other.

Processor 18 as an example of a controller is, for example, a central processing unit (CPU), a digital signal processor (DSP), or a field-programmable gate array (FPGA), and controls operations of units of processor 18. Processor 18 performs various kinds of processing and control in an integrated manner in cooperation with memory 19. Specifically, processor 18 realizes functions of the units by referring to a program and data retained in memory 19 and executing the program. Note that, timing generation unit 17A is also, for example, a CPU, a DSP, an FPGA, or the like, similarly to processor 18.

Processor 18 according to the first exemplary embodiment determines whether or not component P is sucked to suction nozzle 15 corresponding to an output period of the electric signal based on the IV converted value output from current-voltage conversion unit 14E and the electric signal output from timing generation unit 17A. Specifically, processor 18 determines whether or not the IV converted value during the output period of the electric signal by timing generation unit 17A is less than a threshold value. In a case where it is determined that component P is not sucked by suction nozzle 15, processor 18 generates a notification indicating that component P is not sucked and outputs the notification to output unit 20.

Memory 19 includes, for example, a random access memory (RAM) as a work memory used when each processing of processor 18 is executed, and a read only memory (ROM) that stores data and a program that defines an operation of processor 18. Data or information generated or acquired by processor 18 is temporarily stored in the RAM. A program that defines the operation of processor 18 is written to the ROM. Memory 19 stores a threshold value used for detection determination processing of component P executed by processor 18. In addition, memory 19 stores production data for producing a mounting board to be produced.

The production data mentioned here is information used for producing the mounting board by mounting machine 100. The production data includes, for example, a size of board 13, a size and a shape of component P, information on the suction nozzle, the number of produced boards, and the like. Note that, the production data may not be limited to the data of the items described above. The production data may include information on a threshold value for each component P to be described later.

Output unit 20 is, for example, a display such as a liquid crystal display (LCD) or an organic electroluminescence (EL). Output unit 20 outputs the notification output from processor 18.

Here, a scene of the detection of component P by measurement system 14 will be described with reference to Fig. 4. Fig. 4 is a diagram for describing component detection by the measurement system.

As illustrated in Fig. 4, head 11 rotates rotary table 11C by rotor 11B on light ray 14B of measurement system 14, and causes any one suction nozzle 15 among the plurality of suction nozzles 15 to pass on light ray 14B of measurement system 14. Thus, mounting machine 100 can detect only component P sucked to the distal end portion of any one suction nozzle 15 by measurement system 14.

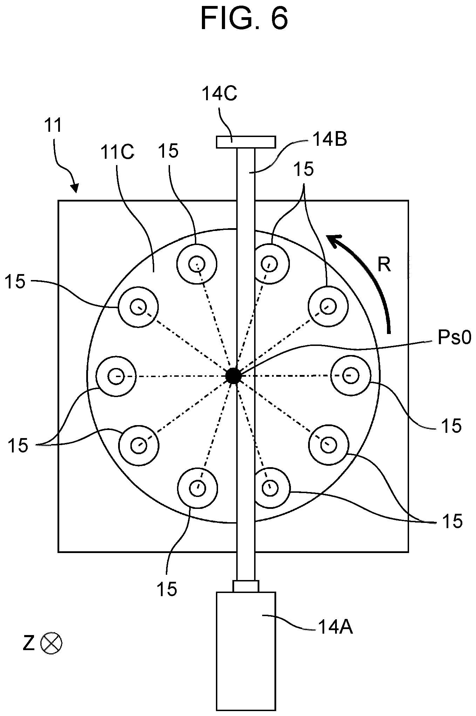

Next, a positional relationship between light ray 14B and each of the plurality of suction nozzles 15 will be described with reference to Figs. 5 and 6. Fig. 5 is a diagram for describing a positional relationship between light ray 14B and each of the plurality of suction nozzles 15. Fig. 6 is a diagram for describing a positional relationship between light ray 14B and each of the plurality of suction nozzles 15. Head 11 illustrated in Figs. 5 and 6 is a diagram viewed from a bottom surface side (that is, -Z direction), and illustrates head 11 in bottom view.

Note that, the number of suction nozzles 15 illustrated in Figs. 5 and 6 is an example, and is not limited thereto. In addition, in head 11 illustrated in Figs. 5 and 6, component P is not illustrated in order to facilitate understanding of the positional relationship between suction nozzle 15 and light ray 14B.

In head 11 at the time of detection determination of component P, the moving mechanism moves rotary table 11C between light source 14A and slit 14C to a position where light ray 14B emitted from light source 14A, passing through slit 14C, and received by photoelectric conversion element 14D does not coincide with rotation center Ps0 of rotary table 11C. Specifically, in head 11 at a detection determination position of component P, light ray 14B emitted from light source 14A, passing through slit 14C, and received by photoelectric conversion element 14D does not coincide with a diagonal line (broken line illustrated in Fig. 6) connecting suction nozzles 15, and rotation center Ps0 of rotary table 11C in bottom view (in a case where head 11 and measurement system 14 are viewed from the -Z direction) does not coincide with light ray 14B. After the head moves to the detection determination position of component P described above, head 11 rotates rotary table 11C by 360° or more in predetermined rotation direction R by rotor 11B. Thus, in mounting machine 100 according to the first exemplary embodiment, since suction nozzles 15 pass through light ray 14B one by one, the detection determination processing of component P can be executed for each suction nozzle 15.

For example, in measurement system 14 at time t1 illustrated in Fig. 5, only suction nozzle 15A and component P (not illustrated) sucked by suction nozzle 15A are positioned on light ray 14B. Thus, measurement system 14 can detect only suction nozzle 15A of the plurality of suction nozzles 15 and component P (not illustrated) sucked by suction nozzle 15A. Similarly, in measurement system 14 at time t2, only suction nozzle 15B and component P (not illustrated) sucked by suction nozzle 15B are positioned on light ray 14B. Thus, measurement system 14 can detect only suction nozzle 15A of the plurality of suction nozzles 15 and component P (not illustrated) sucked by suction nozzle 15A.

In the detection determination processing of component P to be described below, mounting machine 100 sets suction nozzle 15 passing through slit 14C side on light ray 14B as a detection target of component P. For example, in the example illustrated in Fig. 5, mounting machine 100 sequentially executes the detection determination of component P for each of the plurality of suction nozzles 15 rotated in predetermined rotation direction R in a clockwise direction. Mounting machine 100 executes the detection determination of component P for suction nozzle 15A at time 11, and then executes the detection determination of component P for suction nozzle 15C. Note that, the detection target of component P is not limited to the above example. For example, mounting machine 100 may set suction nozzle 15 passing through light source 14A side on light ray 14B as the detection determination target of component P.

As described above, in mounting machine 100 according to the first exemplary embodiment, even though head 11 is of a rotary type, measurement system 14 can detect any one suction nozzle 15 and component P sucked by one suction nozzle 15. Thus, mounting machine 100 according to the first exemplary embodiment can execute the detection determination of component P with higher accuracy.

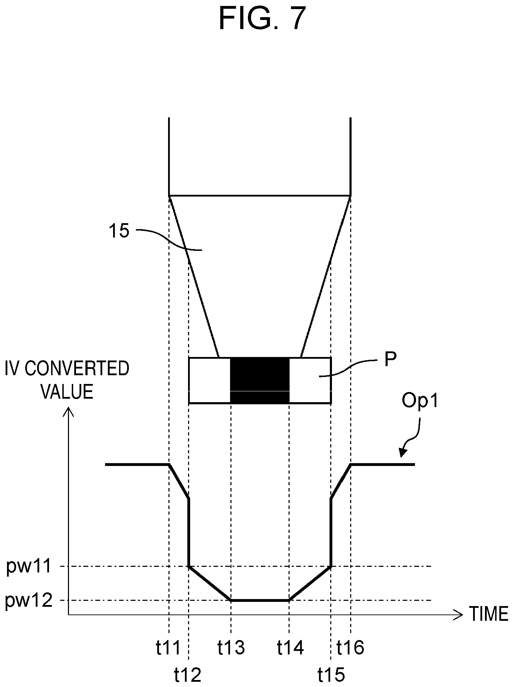

An example of a correspondence relationship between positions of suction nozzle 15 and component P that shield light ray 14B and the IV converted value output from current-voltage conversion unit 14E will be described with reference to Fig. 7. Fig. 7 is a diagram for describing the example of the correspondence relationship between the positions of suction nozzle 15 and component P and the IV converted value. Note that, it goes without saying that suction nozzle 15 and component P illustrated in Fig. 7 are examples, and the present disclosure is not limited thereto.

IV conversion graph Op1 is a graph showing a time-series change in the IV converted value output from current-voltage conversion unit 14E. The IV converted value decreases as a light shielding amount of light ray 14B by suction nozzle 15 and component P increases. Note that, as an example, IV conversion graph Op1 illustrated in Fig. 7 is an IV conversion graph in a case where suction nozzle 15 and component P illustrated in Fig. 7 are detected.

A part of light ray 14B is shielded by suction nozzle 15 between time t11 and time t12, and a light shielding range by suction nozzle 15 and component P expands from time t12 to time t13. Light ray 14B has a maximum light shielding range by suction nozzle 15 and component P between time t13 and time t14, and the light shielding range by suction nozzle 15 and component P decreases between time t14 and time t15. Only a part thereof is shielded by suction nozzle 15 between time t15 and time t16, and the light shielding by suction nozzle 15 disappears after time t16. That is, the light shielding amount at which light ray 14B is shielded becomes the maximum between time t13 and time t14.

Before time t11, light ray 14B is not shielded, and the IV converted value becomes a maximum value. Between time t11 and time t13, the IV converted value continues to decrease as the light shielding amount of light ray 14B increases. The IV converted value becomes minimum pw12 between time t13 and time t14 at which the light shielding amount of light ray 14B becomes the maximum, and continues to increase between time t14 and time t16. The IV converted value becomes the maximum again after time t16.

In addition, in the example illustrated in Fig. 7, in a case where it is determined that the IV converted value output from current-voltage conversion unit 14E is less than or equal to pw11, processor 18 determines that component P sucked by suction nozzle 15 is detected.

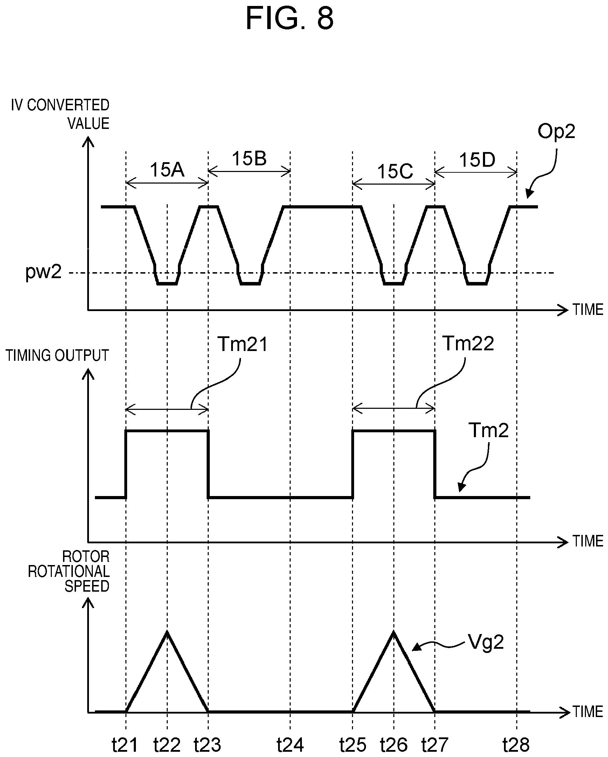

Next, the detection determination processing of component P based on an output timing of the electric signal output by timing generation unit 17A and the IV converted value output from current-voltage conversion unit 14E will be described with reference to Fig. 8. Fig. 8 is a diagram for describing a detection determination processing example of component P according to the first exemplary embodiment. Note that, in Fig. 8, as an example, the detection determination processing example of component P will be described with reference to the positional relationship between each of suction nozzles 15A to 15D and measurement system 14 illustrated in Fig. 5.

Timing output graph Tm2 is a graph showing a time-series change in the electric signal output from timing generation unit 17A. IV conversion graph Op2 is a graph showing the time-series change in the IV converted value output from current-voltage conversion unit 14E.

Timing generation unit 17A generates the electric signal for causing processor 18 to execute the detection determination processing of component P based on the rotation angle of rotor 11B, and outputs the electric signal to processor 18. Specifically, timing generation unit 17A detects (specifies) one suction nozzle 15 passing through slit 14C side of light ray 14B based on a position of head 11 with respect to measurement system 14 and the rotation angle of rotor 11B. For example, at time t2 illustrated in Fig. 5, timing generation unit 17A detects (specifies) suction nozzle 15C as one suction nozzle 15 passing through slit 14C side of light ray 14B.

For example, as illustrated in Fig. 8, rotor 11B continues to accelerate a rotational speed of rotary table 11C from time t21 when the detection determination of component P is started until the timing (time t22) when suction nozzle 15A is positioned on light ray 14B. Rotor 11B decelerates the rotational speed of rotary table 11C from time t22, and controls the rotational speed of rotary table 11C to be 0 (zero) at time t23 when suction nozzle 15A finishes passing on light ray 14B.

Timing generation unit 17A generates the electric signal for causing processor 18 to execute the detection determination processing of component P based on a rotational speed of rotor 11B, and outputs the generated control command to processor 18. Specifically, timing generation unit 17A outputs, to processor 18, the electric signal for executing detection determination of component P based on information on the rotation angle of rotor 11B and the position of head 11 with respect to measurement system 14.

For example, in the example illustrated in Fig. 8, rotor 11B rotates in time zone Tm21 from time t21 to time t23 and time zone Tm22 from time t25 to time t27. Timing generation unit 17A determines that the rotational speed > 0 (zero) in each of time zones Tm21 and Tm22 based on the rotation angle of rotor 11B, and continues to output the electric signal to processor 18 in these time zones Tm21 and Tm22.

While the electric signal is output from timing generation unit 17A (in each of time zones Tm21 and Tm22), processor 18 determines whether or not the IV converted value output from current-voltage conversion unit 14E is more than or equal to threshold value pw2.

In each of time zones Tm21 and Tm22, processor 18 determines whether or not component P is sucked by suction nozzle 15 based on the IV converted value output from current-voltage conversion unit 14E while the electric signal is output from timing generation unit 17A and preset threshold value pw2. Note that, here, threshold value pw2 used for the detection determination of component P may be set to a different value for each component P.

In the example illustrated in Fig. 8, processor 18 determines whether or not the IV converted value output from current-voltage conversion unit 14E in each of time zones Tm21 and Tm22 is more than or equal to threshold value pw2. In a case where it is determined that the IV converted value output from current-voltage conversion unit 14E is more than or equal to threshold value pw2 in time zone Tm21, processor 18 determines that component P is sucked by suction nozzle 15A. On the other hand, in a case where it is determined that the IV converted value output from current-voltage conversion unit 14E is not more than or equal to threshold value pw2, processor 18 determines that component P is not sucked by suction nozzle 15A, generates the notification indicating that component P is not sucked, and outputs the notification to output unit 20.

Similarly, in a case where it is determined that the IV converted value output from current-voltage conversion unit 14E is more than or equal to threshold value pw2 in time zone Tm22, processor 18 determines that component P is sucked by suction nozzle 15C. On the other hand, in a case where it is determined that the IV converted value output from current-voltage conversion unit 14E is not more than or equal to threshold value pw2, processor 18 determines that component P is not sucked by suction nozzle 15C, generates the notification indicating that component P is not sucked, and outputs the notification to output unit 20.

Note that, in a case where the identification information of suction nozzle 15 that is the detection determination target of component P is acquired from timing generation unit 17A, processor 18 may output the identification information of suction nozzle 15 and the notification to output unit 20 in association with each other. In addition, processor 18 may store the generated notification or the notification associated with the identification information of suction nozzle 15 in memory 19.

As described above, even though head 11 is of the rotary type, mounting machine 100 according to the first exemplary embodiment can execute the detection determination processing of component P only while the electric signal is output from timing generation unit 17A (for example, in time zone Tm21 or Tm22), and thus, the detection determination of component P for one suction nozzle 15 (for example, suction nozzles 15A and 15C illustrated in Fig. 5) passing through slit 14C side of light ray 14B.

### (Modification of first exemplary embodiment)

An example in which mounting machine 100 according to the first exemplary embodiment executes the detection determination processing of component P of any one of suction nozzles 15 based on the IV converted value output at a predetermined timing (for example, time zone Tm21 or Tm22 illustrated in Fig. 8) based on the rotation angle of rotor 11B of head 11 has been described. An example in which mounting machine 100A according to a modification of the first exemplary embodiment executes on and off control of light source 14A based on the rotational speed of rotor 11B of head 11 and executes the detection determination processing of component P of any one suction nozzle 15 based on the IV converted value output from current-voltage conversion unit 14E will be described.

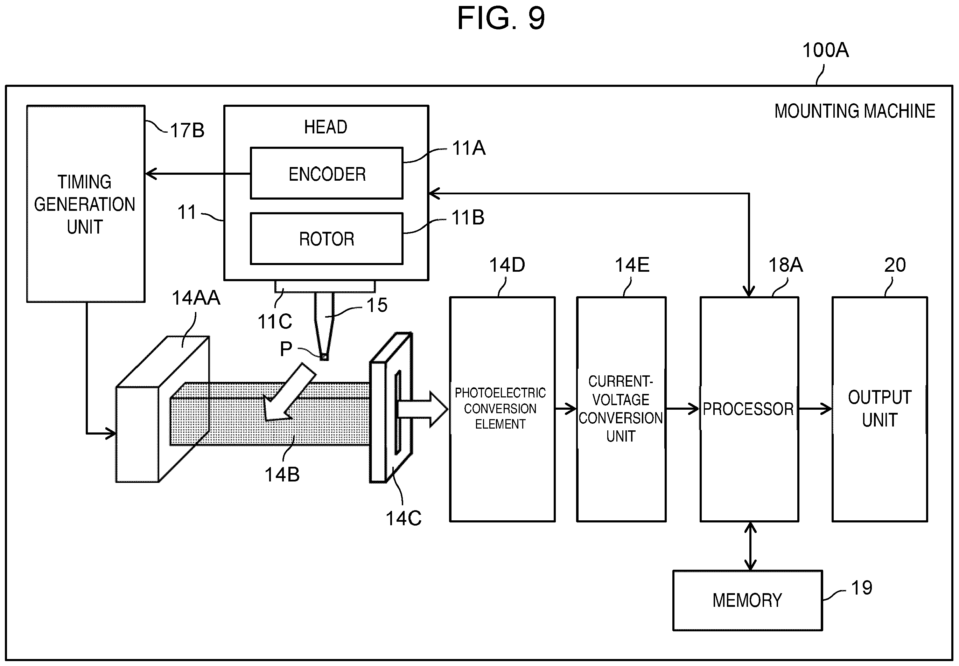

An internal configuration example of mounting machine 100A according to the modification of the first exemplary embodiment will be described with reference to Fig. 9. Fig. 9 is a block diagram illustrating an internal configuration example of mounting machine 100A according to the modification of the first exemplary embodiment. Note that, mounting machine 100A according to the modification of the first exemplary embodiment has substantially a configuration identical to the configuration of mounting machine 100 according to the first exemplary embodiment. Thus, constituent elements identical to the components in the first exemplary embodiment will be denoted by identical reference marks, and the description thereof will be omitted.

Encoder 11A according to the modification of the first exemplary embodiment detects the rotation angle of rotor 11B by the sensor, and outputs the information on the detected rotation angle of rotor 11B to timing generation unit 17B. Note that, encoder 11A may output the information on the rotation angle of rotor 11B to processor 18A. Thus, processor 18A can specify one suction nozzle 15 that is the detection determination target of component P among the plurality of suction nozzles 15 included in head 11.

Timing generation unit 17B as an example of the determination unit determines whether or not rotor 11B is rotating (that is, whether or not the rotational speed of rotor 11B > 0 (zero) is satisfied) based on the information on the rotation angle of rotor 11B output from encoder 11A. In a case where it is determined that rotor 11B is rotating, timing generation unit 17B generates an electric signal for turning on light source 14AA (that is, emitting light ray 14B) and outputs the electric signal to light source 14AA.

Light source 14AA is controlled by timing generation unit 17B. Light source 14AA is turned on while the electric signal is output from timing generation unit 17B, and emits light ray 14B. In addition, light source 14AA is turned off while the electric signal is not output from timing generation unit 17B, and does not emit light ray 14B.

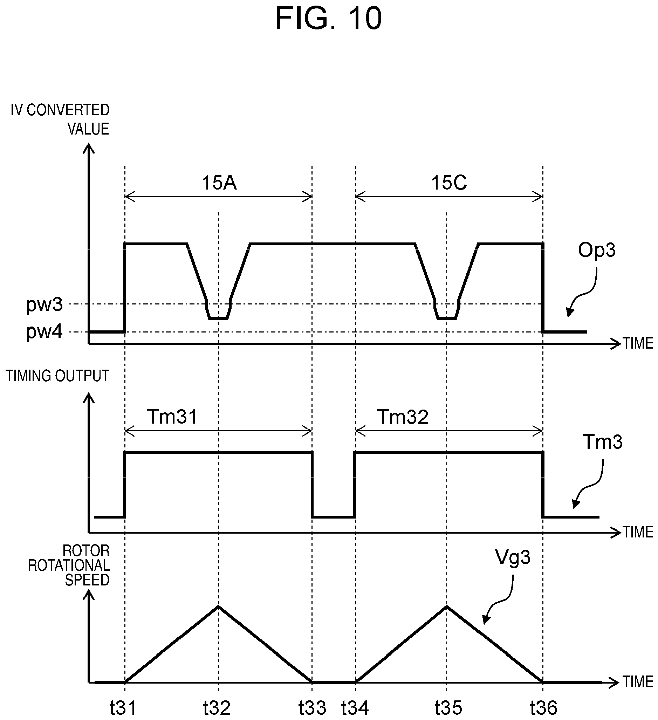

Processor 18A as an example of the controller specifies suction nozzle 15 that is the detection determination target of component P based on the rotation angle of rotor 11B output from encoder 11A. In addition, processor 18A determines whether or not the IV converted value output from current-voltage conversion unit 14E is less than threshold value pw3 (see Fig. 10) corresponding to the detection target of component P and is more than threshold value pw4. In a case where it is determined that the IV converted value is less than threshold value pw3 and is more than threshold value pw4, processor 18A determines that component P is sucked by suction nozzle 15. On the other hand, in a case where it is determined that the IV converted value is more than or equal to threshold value pw3 or less than or equal to threshold value pw4, processor 18A determines that component P is not sucked by suction nozzle 15.

Next, the detection determination processing of component P based on the rotational speed of rotor 11B, the output timing of the electric signal output by timing generation unit 17B, and the IV converted value output from current-voltage conversion unit 14E will be described with reference to Fig. 10. Fig. 10 is a diagram for describing a detection determination processing example of component P according to the modification of the first exemplary embodiment. Note that, in Fig. 10, as an example, the detection determination processing example of component P will be described while referring to the positional relationship between each of suction nozzles 15A to 15D and measurement system 14 illustrated in Fig. 5.

Rotor rotational speed graph Vg3 is a graph showing the rotational speed of rotor 11B based on the information on the rotation angle of rotor 11B. Timing output graph Tm3 is a graph showing a time-series change in the electric signal output from timing generation unit 17B. IV conversion graph Op3 is a graph showing the time-series change in the IV converted value output from current-voltage conversion unit 14E.

Here, the rotation control of rotary table 11C by rotor 11B will be described. Rotor 11B continues to accelerate the rotational speed of rotary table 11C until a distal end center of suction nozzle 15 that is the detection target of component P is positioned on light ray 14B. Rotor 11B decelerates the rotational speed of rotary table 11C at a timing when substantially the distal end center of suction nozzle 15 is positioned on light ray 14B, and performs control such that the rotational speed of rotary table 11C becomes 0 (zero) at a timing when substantially an intermediate position between suction nozzle 15 (for example, suction nozzle 15A illustrated in Fig. 5) that is the detection target of component P and suction nozzle 15 (for example, suction nozzle 15C illustrated in Fig. 5) that is the detection target of the next component P is positioned on light ray 14B.

For example, as illustrated in Fig. 10, rotor 11B continues to accelerate the rotational speed of rotary table 11C from time t31 when the detection determination of component P is started until a timing (time t32) when suction nozzle 15A is positioned on light ray 14B. Rotor 11B decelerates the rotational speed of rotary table 11C from time t32, and controls the rotational speed of rotary table 11C to be 0 (zero) at time t33 when suction nozzle 15A finishes passing on light ray 14B.

Timing generation unit 17B generates an electric signal for executing on and off control of the emission of light ray 14B based on the rotational speed of rotor 11B, and outputs the electric signal to light source 14AA. Specifically, timing generation unit 17B detects (specifies) one suction nozzle 15 passing through slit 14C side of light ray 14B based on the information on the rotation angle of rotor 11B and the position of head 11 with respect to measurement system 14.

Timing generation unit 17B continues to output an electric signal to light source 14AA based on the information on the rotation angle of rotor 11B. For example, in the example illustrated in Fig. 10, rotor 11B rotates in time zone Tm31 from time t31 to time t33 and time zone Tm32 from time t34 to time t36. Based on the rotation angle of rotor 11B, timing generation unit 17B determines that the rotational speed > 0 (zero) in each of time zones Tm31 and Tm32, and continues to output an electric signal for on control of light source 14AA in each of time zones Tm31 and Tm32.

Light source 14AA continues to emit light ray 14B while the electric signal is output from timing generation unit 17B (in time zone Tm31 or Tm32).

Photoelectric conversion element 14D receives light ray 14B passing through slit 14C, and converts the light ray into an electric signal (current) corresponding to intensity of received light ray 14B. Photoelectric conversion element 14D outputs the converted electric signal to current-voltage conversion unit 14E.

Current-voltage conversion unit 14E converts the electric signal output from photoelectric conversion element 14D into the IV converted value and outputs the IV converted value to processor 18A.

Processor 18A determines whether or not component P is sucked by suction nozzle 15 based on the IV converted value output from current-voltage conversion unit 14E and preset each of threshold values pw3 and pw4. Threshold value pw4 is a value less than threshold value pw3, and indicates the IV converted value when light source 14AA is in an off state, that is, the IV converted value when the intensity of light ray 14B output from photoelectric conversion element 14D is 0 (zero). Note that, here, threshold value pw3 used for the detection determination of component P may be set to a different value for each component P. In addition, processor 18A specifies one suction nozzle 15 that is the detection determination target of component P based on the information on the rotation angle of rotor 11B output from encoder 11A.

In the example illustrated in Fig. 10, processor 18A outputs the IV converted value from current-voltage conversion unit 14E in each of time zones Tm31 and Tm32. Processor 18A determines whether or not the IV converted value output from current-voltage conversion unit 14E is more than or equal to threshold value pw3. in a case where it is determined that the IV converted value output from current-voltage conversion unit 14E is less than threshold value pw3 and is more than threshold value pw4 in time zone Tm31, processor 18A determines that component P is sucked by suction nozzle 15A. Note that, in a case where it is determined that the IV converted value output from current-voltage conversion unit 14E is more than or equal to threshold value pw3 or is less than or equal to threshold value pw4 in time zone Tm31, processor 18A determines that component P is not sucked by suction nozzle 15A, generates the notification indicating that component P is not sucked, and outputs the notification to output unit 20.

Similarly, processor 18A determines that the IV converted value output from current-voltage conversion unit 14E is less than threshold value pw3 and is more than threshold value pw4 in time zone Tm32, and determines that component P is sucked by suction nozzle 15C.

Note that, in a case where it is determined that the IV converted value output from current-voltage conversion unit 14E is more than or equal to threshold value pw3 or is less than or equal to threshold value pw4, processor 18A determines that component P is not sucked by suction nozzle 15C, generates the notification indicating that component P is not sucked, and outputs the notification to output unit 20.

In addition, in a case where it is determined that component P is not sucked by suction nozzle 15 C, processor 18A may output the identification information of suction nozzle 15 and the notification to output unit 20 in association with each other. In addition, processor 18A may store the generated notification or the notification associated with the identification information of suction nozzle 15 in memory 19.

As described above, mounting machine 100A according to the modification of the first exemplary embodiment can emit light ray 14B only while suction nozzle 15 that is the detection determination target of component P passes on light ray 14B even though head 11 is of the rotary type. Thus, since mounting machine 100A according to the modification of the first exemplary embodiment can more effectively acquire the IV converted value of suction nozzle 15 that is the detection determination target of component P in the detection determination processing of component P, it is possible to further improve the detection determination accuracy of component P.

As described above, mounting machine 100 or 100A according to the first exemplary embodiment or the modification of the first exemplary embodiment includes head 11 (an example of the rotary head) that sucks component P at the distal end portion of each of the plurality of suction nozzles 15 disposed circumferentially to mount component P on board 13, measurement system 14 (an example of measurement system 14) that includes light source 14A or 14AA and photoelectric conversion element 14D (an example of the light receiver) that receives light ray 14B emitted from light source 14A or 14AA, and emits light ray 14B to the distal end portion of suction nozzle 15 to output the IV converted value (an example of light intensity) of light ray 14B received by photoelectric conversion element 14D, and processor 18 or 18A that determines whether or not suction nozzle 15 rotated in a circumferential direction by head 11 and passing through light ray 14B is sucking component P based on the IV converted value of light ray 14B output from measurement system 14. Head 11 rotates the plurality of suction nozzles 15 in the circumferential direction (for example, rotation direction R illustrated in Figs. 5 and 6) between light source 14A or 14AA and photoelectric conversion element 14D and at a position where light ray 14B does not coincide with rotation center Ps0 of head 11 in bottom view. Processor 18 or 18A determines whether or not suction nozzle 15 passing through light ray 14B is sucking component P based on the output IV converted value of light ray 14B.

Thus, in mounting machine 100 or 100A according to the first exemplary embodiment or the modification of the first exemplary embodiment, head 11 rotates rotary table 11C by 360° or more at a position where light ray 14B does not coincide with rotation center Ps0 of head 11 as the center position (rotation center Ps0) of the circumference that is the detection determination position of component P, and thus, it is possible to prevent two or more suction nozzles 15 from simultaneously passing on light ray 14B. That is, mounting machine 100 or 100A can execute the detection determination processing of component P for each suction nozzle 15. In addition, mounting machine 100 or 100A according to the first exemplary embodiment or the modification of the first exemplary embodiment can determine whether or not component P is sucked by suction nozzle 15 based on the output IV converted value of light ray 14B.

In addition, as described above, in a case where it is determined that the IV converted value of output light ray 14B is less than the threshold value (for example, threshold values pw1, pw2, pw3, or the like), processor 18 or 18A in mounting machine 100 or 100A according to the first exemplary embodiment or the modification of the first exemplary embodiment determines that suction nozzle 15 passing through light ray 14B is sucking component P. Thus, in a case where the IV converted value (light amount) of output light ray 14B is less than the threshold value, mounting machine 100 or 100A according to the first exemplary embodiment or the modification of the first exemplary embodiment can determine that light ray 14B is shielded by suction nozzle 15 and component P sucked by suction nozzle 15.

In addition, as described above, in a case where it is determined that the IV converted value of output light ray 14B is not less than the threshold value (for example, threshold values pw1, pw2, pw3, or the like), processor 18 or 18A in mounting machine 100 or 100A according to the first exemplary embodiment or the modification of the first exemplary embodiment determines that suction nozzle 15 passing through light ray 14B is not sucking component P, and generates and outputs a notification indicating that suction nozzle 15 is not sucking component P. Thus, in a case where the IV converted value of output light ray 14B is not less than the threshold value, mounting machine 100 or 100A according to the first exemplary embodiment or the modification of the first exemplary embodiment can determine that light ray 14B is not shielded by suction nozzle 15 and component P sucked by suction nozzle 15.

In addition, as described above, mounting machine 100 according to the first exemplary embodiment further includes timing generation unit 17A (an example of the determination unit) that determines a first timing when it is determined whether or not suction nozzle 15 passing through light ray 14B is sucking component P. Head 11 measures rotational speeds of the plurality of suction nozzles 15 in the circumferential direction, and outputs the rotational speeds to timing generation unit 17A. Timing generation unit 17A determines the first timing (for example, time zone Tm21 or Tm22 illustrated in Fig. 8, or the like) when it is determined whether or not suction nozzle 15 passing through light ray 14B is sucking component P based on the output rotational speed. Processor 18 determines whether or not suction nozzle 15 passing through light ray 14B is sucking component P based on the IV converted value of light ray 14B output from measurement system 14 at the first timing determined by timing generation unit 17A. Thus, mounting machine 100 according to the first exemplary embodiment executes the detection determination processing of component P only while the electric signal is output from timing generation unit 17A (for example, in time zone Tm21 or Tm22), and thus, the IV converted value corresponding to suction nozzle 15 (that is, passing through light ray 14B) that is the detection determination target of component P can be more effectively acquired. As a result, the detection determination of component P can be executed with higher accuracy.

In addition, as described above, timing generation unit 17A in mounting machine 100 according to the first exemplary embodiment determines the time zone (for example, time zone Tm21 or Tm22) in which it is determined that the rotational speed > 0 (zero) as the first timing. Thus, mounting machine 100 according to the first exemplary embodiment can execute the detection determination processing of component P based on the IV converted value output in the time zone in which suction nozzle 15 that is the detection determination target of component P is rotated by head 11 and passes light ray 14B. Therefore, mounting machine 100 can more effectively acquire the IV converted value corresponding to suction nozzle 15 (that is, passing through light ray 14B) that is the detection determination target of component P, and can execute the detection determination of component P with higher accuracy.

In addition, as described above, mounting machine 100A according to the modification of the first exemplary embodiment further includes timing generation unit 17B that determines a second timing (for example, time zone Tm31 or Tm32 illustrated in Fig. 10, or the like) when light source 14AA emits light ray 14B. Head 11 measures the rotational speeds of the plurality of suction nozzles 15 in the circumferential direction, and outputs the rotational speeds to timing generation unit 17B. Timing generation unit 17B determines the second timing when light ray 14B is emitted based on the output rotational speed. Measurement system 14 emits light ray 14B at the second timing determined by timing generation unit 17B. Thus, mounting machine 100A according to the modification of the first exemplary embodiment can acquire the IV converted value in the time zone in which suction nozzle 15 that is the detection determination target of component P passes through light ray 14B by emitting light ray 14B only while the electric signal is output from timing generation unit 17B (for example, in time zone Tm21 or Tm22). That is, mounting machine 100A can more effectively acquire the IV converted value corresponding to suction nozzle 15 (that is, passing through light ray 14B) that is the detection determination target of component P, and can execute the detection determination of component P with higher accuracy.

In addition, as described above, timing generation unit 17B in mounting machine 100A according to the modification of the first exemplary embodiment determines the time zone (for example, time zone Tm31 or Tm32 illustrated in Fig. 10, or the like) in which it is determined that the rotational speed > 0 (zero) as the second timing. Thus, mounting machine 100A according to the modification of the first exemplary embodiment emits light ray 14B only while suction nozzle 15 that is the detection determination target of component P is rotated by head 11, and thus, the IV converted value corresponding to suction nozzle 15 (that is, passing through light ray 14B) that is the detection determination target of component P can be more effectively acquired. As a result, the detection determination of component P can be executed with higher accuracy.

In addition, as described above, measurement system 14 in mounting machine 100 or 100A according to the first exemplary embodiment or the modification of the first exemplary embodiment has slit 14C between light source 14A or 14AA and photoelectric conversion element 14D, and outputs the IV converted value of light ray 14B passing through slit 14C. Thus, mounting machine 100 or 100A according to the first exemplary embodiment or the modification of the first exemplary embodiment can more effectively acquire the IV converted value corresponding to suction nozzle 15 that is the detection determination target of component P (that is, passing through light ray 14B).

### (Second exemplary embodiment)

An example in which mounting machine 100A according to the modification of the first exemplary embodiment executes the on and off control of light source 14AA by timing generation unit 17B and executes the detection determination processing of component P based on the intensity of light ray 14B emitted from light source 14AA has been described. An example in which mounting machine 100B according to a second exemplary embodiment executes on and off control of transmissive illumination 14G by timing generation unit 17B, captures suction nozzle 15 passing through light ray 14H by using transmissive illumination 14G, and executes the detection determination processing of component P by using the captured image will be described. Transmissive illumination 14G of the present exemplary embodiment may include a light source similar to light source 14A of the first exemplary embodiment.

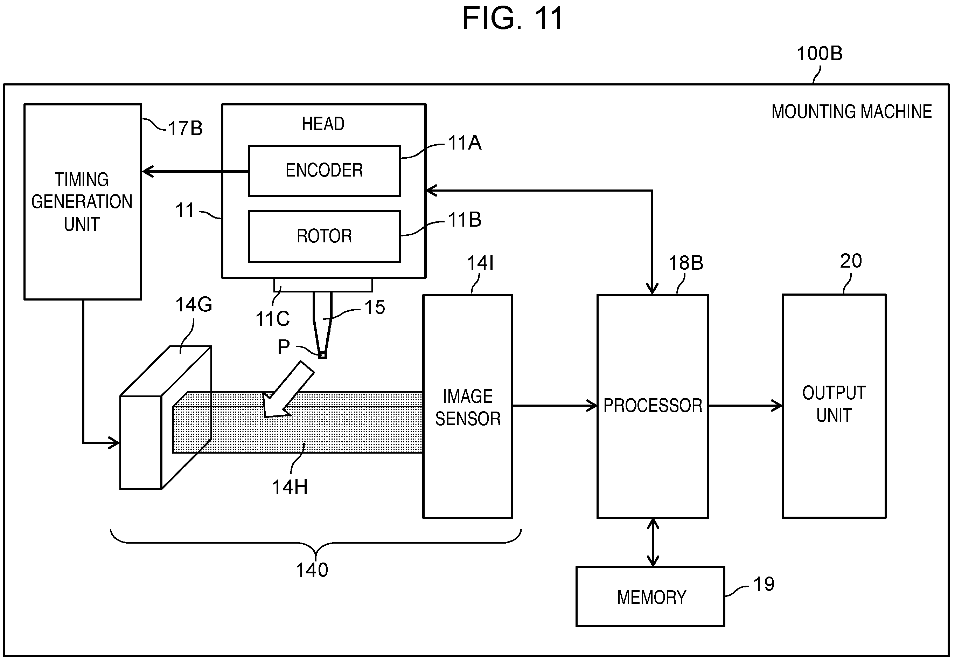

First, an internal configuration example of mounting machine 100B according to the second exemplary embodiment will be described with reference to Fig. 11. Fig. 11 is a block diagram illustrating the internal configuration example of mounting machine 100B according to the second exemplary embodiment. Note that, mounting machine 100B according to the second exemplary embodiment has substantially a configuration identical to the configuration of mounting machine 100A according to the modification of the first exemplary embodiment. Thus, constituent elements identical to the components in the modification of the first exemplary embodiment will be denoted by identical reference marks, and the description thereof will be omitted.

Mounting machine 100B according to the second exemplary embodiment includes imaging system 140 (an example of the sensor) instead of measurement system 14. Imaging system 140 includes transmissive illumination 14G and image sensor 14I. Imaging system 140 captures suction nozzle 15 passing through light ray 14H emitted by transmissive illumination 14G, and outputs the captured image to processor 18B. Processor 18B executes the detection determination processing of component P based on the captured image output from image sensor 14I.

Timing generation unit 17B as an example of the determination unit determines whether or not rotor 11B is rotating (that is, whether or not the rotational speed of rotor 11B > 0 (zero) is satisfied) based on the information on the rotation angle of rotor 11B output from encoder 11A. In a case where it is determined that rotor 11B is rotating, timing generation unit 17B generates an electric signal for turning on (that is, emitting light ray 14H) transmissive illumination 14G and outputs the electric signal to transmissive illumination 14G.

Transmissive illumination 14G is controlled by timing generation unit 17B. Transmissive illumination 14G is turned on while the electric signal is output from timing generation unit 17B, and emits light ray 14H to facing image sensor 14I. In addition, transmissive illumination 14G is turned off while the electric signal is not output from timing generation unit 17B, and does not emit light ray 14B.

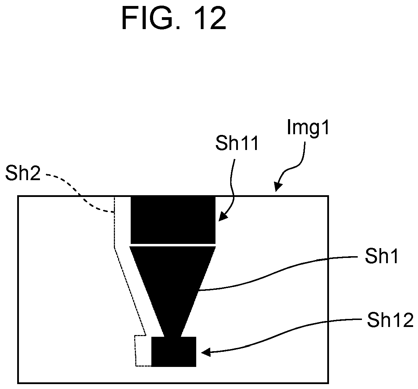

Image sensor 14I is, for example, a solid-state imaging element of a complementary metal oxide semiconductor (CMOS), and converts an optical image formed on an imaging surface into an electric signal. Image sensor 14I outputs captured image Img1 (see Fig. 12) to processor 18B.

Processor 18B as an example of the controller executes image recognition processing on the captured image (see Fig. 11) output from image sensor 14I, and detects component P from the distal end portion of suction nozzle 15 that is the detection determination target of component P. In a case where component P is detected from the distal end portion of suction nozzle 15 as a result of image processing, processor 18B determines that component P is sucked by suction nozzle 15. In a case where component P is not detected from the distal end portion of suction nozzle 15 as a result of the image processing, processor 18B determines that component P is not sucked by suction nozzle 15.

Next, the detection determination processing of component P using captured image Img1 captured by imaging system 140 will be described with reference to Fig. 12. Fig. 12 is a diagram for describing a detection determination processing example of component P according to the second exemplary embodiment. Note that, in Fig. 12, as an example, the detection determination processing example of component P will be described while referring to the positional relationship between each of suction nozzles 15A to 15D and measurement system 14 (an example of imaging system 140) illustrated in Fig. 5.

For example, captured image Img1 is a captured image in which shadow Sh1 of suction nozzle 15 (for example, suction nozzle 15A illustrated in Fig. 5) that is detection determination target of component P and shadow Sh2 of suction nozzle 15 (for example, suction nozzle 15B illustrated in Fig. 5) positioned opposite to suction nozzle 15 with rotation center Ps0 interposed therebetween appear.

Processor 18B executes the image recognition processing on captured image Img1 output from image sensor 14I, and detects each of shadows Sh1 and Sh2 based on the shading of each of two suction nozzles 15 appearing in captured image Img1. Processor 18B selects shadow Sh1 corresponding to suction nozzle 15 that is the detection determination target of component P based on the shading of the shadow of each of two detected shadows Sh1 and Sh2, and detects shadow Sh11 of suction nozzle 15 and shadow Sh12 of component P from shadow Sh1 by the image recognition processing.

In the example illustrated in Fig. 12, processor 18B detects shadow Sh12 of component P from shadow Sh1 by the image recognition processing, and determines that component P is sucked by suction nozzle 15 A.

Note that, in a case where it is determined that shadow Sh12 of component P cannot be detected from shadow Sh1 by the image recognition processing, processor 18B determines that component P is not sucked by suction nozzle 15A, generates the notification indicating that component P is not sucked, and outputs the notification to output unit 20.

In addition, in a case where it is determined that component P is not sucked by suction nozzle 15A, processor 18B may output the identification information of suction nozzle 15 and the notification to output unit 20 in association with each other. In addition, processor 18B may store the generated notification or the notification associated with the identification information of suction nozzle 15 in memory 19.

As described above, even though head 11 is of the rotary type, mounting machine 100B according to the second exemplary embodiment can capture shadow Sh1 of suction nozzle 15 that is the detection determination target of component P by emitting light ray 14H with transmissive illumination 14G only while suction nozzle 15 that is the detection determination target of component P passes on light ray 14H. In addition, even in a case where each of two suction nozzles 15 appears in captured image Img1, since the shading of shadows Sh1 and Sh2 of each of two suction nozzles 15 is different by using transmissive illumination 14G, mounting machine 100B can more accurately detect shadow Sh1 of suction nozzle 15 that is the detection determination target of component P and shadow Sh12 of component P sucked by suction nozzle 15 by executing the image recognition processing.

As described above, mounting machine 100B according to the second exemplary embodiment includes head 11 (an example of the rotary head) that sucks component P at the distal end portion of each of the plurality of suction nozzles 15 disposed circumferentially to mount component P on board 13, imaging system 140 (an example of the sensor) that includes transmissive illumination 14G and image sensor 14I that receives light ray 14B emitted from transmissive illumination 14G, and emits light ray 14H to the distal end portion of suction nozzle 15, and generates captured image Img1 on which suction nozzle 15 rotated in the circumferential direction by head 11 and passing through light ray 14H is captured based on light ray 14H received by image sensor 14I, and processor 18B (an example of the controller) that acquires shadow Sh1 of suction nozzle 15 appearing in captured image Img1 output from imaging system 140 and determines whether or not suction nozzle 15 is sucking component P based on shadow Sh1. Head 11 rotates the plurality of suction nozzles 15 in the circumferential direction (for example, rotation direction R illustrated in Figs. 5 and 6) between transmissive illumination 14G and image sensor 14I and at a position where light ray 14H does not coincide with rotation center Ps0 of head 11 in bottom view.

Thus, in mounting machine 100B according to the second exemplary embodiment, head 11 rotates rotary table 11C by 360° or more at a position where light ray 14H does not coincide with rotation center Ps0 of head 11 as the center position (rotation center Ps0) of the circumference that is the detection determination position of component P, and thus, it is possible to prevent two or more suction nozzles 15 from simultaneously passing on light ray 14H. As a result, only suction nozzle 15 that is the detection determination target of component P can be captured. That is, mounting machine 100B can execute the detection determination processing of component P for each suction nozzle 15. Thus, mounting machine 100B can determine whether or not component P is sucked by suction nozzle 15 based on shadow Sh1 appearing in captured image Img1 (see Fig. 12).

Although various exemplary embodiments have been described above with reference to the accompanying drawings, the present disclosure is not limited to such examples. It is obvious that those skilled in the art can conceive various changes, modifications, substitutions, additions, deletions, and equivalents within the scope described in the claims, and it is understood that these also belong to the technical scope of the present disclosure. In addition, the constituent elements in the above-described various exemplary embodiments may be arbitrarily combined without departing from the gist of the invention.

### INDUSTRIAL APPLICABILITY

The present disclosure is useful for presenting the mounting machine capable of more accurately detecting the component sucked by each of the plurality of suction nozzles provided in the head of the rotary type.

### REFERENCE MARKS IN THE DRAWINGS

11: head
13: board
14: measurement system
14A, 14AA: light source
14B, 14H: light ray
14C: slit
14D: photoelectric conversion element
14E: current-voltage conversion unit
14G: transmissive illumination
14I: image sensor
15: suction nozzle
17A, 17B: timing generation unit
18, 18A, 18B: processor
20: output unit
100, 100A, 100B: mounting machine
140: imaging system
P: component
Ps0: rotation center
Img1: captured image
Sh1, Sh11, Sh12, Sh2: shadow

## Claims

1. A mounting machine comprising:
a rotary head that includes a plurality of suction nozzles disposed circumferentially, the rotary head being configured to suck a component at a distal end portion of a suction nozzle among the plurality of suction nozzles to mount the component on a board;
a sensor that includes a light source and a light receiver, the light source being configured to emit a light ray to the distal end portion of the suction nozzle, the light receiver being configured to receive the light ray emitted from the light source, and the sensor being configured to output light intensity of the light ray received by the light receiver; and
a controller that determines, based on the light intensity of the light ray output from the sensor, whether or not the suction nozzle is sucking the component when the rotary head rotates the plurality of suction nozzles in a circumferential direction and the suction nozzle passes through the light ray,
wherein the rotary head rotates the plurality of suction nozzles in the circumferential direction when the rotary head is present between the light source and the light receiver, and the light ray does not coincide with a rotation center of the rotary head in bottom view.

2. The mounting machine according to Claim 1, wherein the controller determines that the suction nozzle is sucking the component when it is determined that the output light intensity of the light ray is less than a threshold value.

3. The mounting machine according to Claim 1, wherein the controller determines that the suction nozzle is not sucking the component, and generates and outputs a notification indicating that the suction nozzle is not sucking the component when the output light intensity of the light ray is not less than a threshold value.

4. The mounting machine according to Claim 1, wherein
the rotary head measures a rotational speed of the plurality of suction nozzles rotated in the circumferential direction, and outputs the rotational speed,
the mounting machine further includes a determination unit that determines a first timing based on the output rotational speed,
the sensor outputs the light intensity of the light ray at the first timing determined by the determination unit, and
the controller determines whether or not the suction nozzle is sucking the component based on the light intensity of the light ray output form the sensor at the first timing.

5. The mounting machine according to Claim 4, wherein the determination unit determines, as the first timing, a time zone in which the rotational speed is more than zero.

6. The mounting machine according to Claim 1, wherein
the rotary head measures a rotational speed of the plurality of suction nozzles rotated in the circumferential direction, and outputs the rotational speed,
the mounting machine further includes a determination unit that determines a second timing based on the output rotational speed, and
the sensor emits the light ray at the second timing determined by the determination unit.

7. The mounting machine according to Claim 6, wherein the determination unit determines, as the second timing, a time zone in which the rotational speed is more than zero.

8. The mounting machine according to Claim 1, wherein the sensor has a slit disposed between the light source and the light receiver, and outputs the light intensity of the light ray passing through the slit.

9. A mounting machine comprising:
a rotary head that includes a plurality of suction nozzles disposed circumferentially, the rotary head being configured to suck a component at a distal end portion of a suction nozzle among the plurality of suction nozzles to mount the component on a board;
a sensor that includes a transmissive illumination and an image sensor, the transmissive illumination being configured to emit a light ray to the distal end portion of the suction nozzle, the image sensor being configured to receive the light ray emitted from the transmissive illumination, and the sensor being configured to generate a captured image on which the suction nozzle when the rotary head rotates the plurality of suction nozzles in a circumferential direction and the suction nozzle passes through the light ray is captured based on the light ray received by the image sensor; and
a controller that acquires a shadow of the suction nozzle captured on the captured image output from the sensor, and determines whether or not the suction nozzle is sucking the component based on the shadow,
wherein the rotary head rotates the plurality of suction nozzles in the circumferential direction when the rotary head is present between the transmissive illumination and the image sensor, and the light ray does not coincide with a rotation center of the rotary head in bottom view.
